# FASCICULE DE BREVET EUROPEEN

(11) **EP 0 377 205 B1**
(45) Date de publication et mention de la délivrance du brevet: **31.08.1994**
(21) Numéro de dépôt: 89123958.4
(22) Date de dépôt: 27.12.1989
(51) Int. Cl.: H03G 3/20, H03G 11/02

(54) **Limiteur en courant et récepteur optique en faisant application**
Strombegrenzer und seine Verwendung in einem optischen Empfänger
Current limiter and optical receiver using it

(30) Priorité: 30.12.1988 FR 8817508
(43) Date de publication de la demande: 11.07.1990
(73) Titulaire: ALCATEL CIT, 75008 Paris (FR)
(72) Inventeur: Gauthier, Claude, F-91880 Bouville (FR); Balland, Guy, F-75013 Paris (FR)
(74) Mandataire: Weinmiller, Jürgen

(56) Documents cités:
- US-A- 3 248 569
- US-A- 4 096 382
- US-A- 4 683 443
- US-A- 4 746 821
- ELECTRONICS, vol. 44, no. 4, 15 février 1971, page 87; R.J. TURNER: "Series limiter tracks signal, finds symmetry"

## Description

La présente invention concerne un circuit limiteur de courant utilisable, notamment, dans le circuit d'entrée du préamplificateur d'un récepteur de liaison optique.

Une liaison de ce genre est décrite, par exemple, dans l'article "Système urbain de transmission sur fibre optique unimodale à 140 et 34 Mbit/s (FOT140/34)", publié D. Betoule et al dans la revue "Commutation et transmission", n° 2, 1988. On y donne également quelques indications concernant le récepteur, lequel comprend, pour la conversion optoélectrique, une photodiode à avalanche (PDA), dont le gain est commandé par une boucle de commande automatique de niveau. Ensuite, l'amplification linéaire du signal est effectuée au moyen d'un étage à transimpédance à faible bruit. Plus précisément, il y est indiqué que, l'affaiblissement le long de la liaison à fibre optique, entre l'émetteur et le récepteur, pouvant varier, selon les applications, de 0 à 28 dB, la dynamique correspondante du récepteur est obtenue, à la mise en service, par le choix entre deux plages de fonctionnement.

Dans une telle liaison, lorsque l'affaiblissement est de 28 dB, le signal reçu est faible. C'est ce qui nécessite une amplification à faible bruit. Le gain doit aussi être relativement élevé, en vue du traitement ultérieur du signal. Mais, l'affaiblissement peut être seulement de 0 dB, dans le cas d'une liaison extrêmement courte ou lorsque, pour essais, l'émetteur d'une liaison d'émission est directement bouclé sur le récepteur de la liaison de réception associée. En l'absence de toute précaution, la photodiode employée risque alors de fournir un signal sortant de la plage de fonctionnement du préamplificateur, ce qui rendra la liaison inexploitable.

En dehors du cas traité dans la publication citée plus haut, ce problème a déjà fait l'objet d'un certain nombre de solutions.

Ainsi, on a déjà envisagé l'emploi d'un élément atténuant le signal lumineux reçu par la photodiode, sous la forme d'un atténuateur optique, tel que celui qui fait l'objet du document de brevet FR-A-8517277, ou plus simplement d'un complément de longueur de fibre optique. De telles solutions sont onéreuses et demandent une intervention humaine, au moment de leur mise en oeuvre, ce qui les rend inacceptables dans certaines applications.

Dans l'article cité plus haut, c'est la sensibilité de la photodiode qui est réduite, par action sur son courant de polarisation. On trouvera également une illustration de ce type de solution dans le document de brevet WO-A-85/04997. La variation de dynamique obtenue par de tels moyens est insuffisante pour subvenir aux besoins. D'ailleurs, dans l'article considéré, il est mentionné un choix de dynamique effectué à la mise en service, lequel ne permettrait pas de résoudre le problème que posent les essais avec bouclage de l'émetteur sur le récepteur sans que soit alors nécessaire une intervention humaine.

Il a encore été envisagé d'agir sur la dynamique du préamplificateur. Une telle solution est illustrée, par exemple, par l'amplificateur à transimpédance TIA 1500 de la firme américaine MSC, Microwave Semiconductor Corp. Elle est, elle aussi, limitée en ce qui concerne les variations de dynamique. De plus, l'amplificateur ainsi modifié est d'un prix relativement élevé.

La présente invention a pour but d'améliorer la dynamique de fonctionnement d'un récepteur optique à photodétecteur générateur de courant et étage d'amplification électrique à basse impédance, de manière à satisfaire en particulier aux besoins mentionnés précédemment, et ce en ne faisant appel qu'à des moyens simples, peu onéreux et ne nécessitant pas d'intervention humaine.

La présente invention propose pour ce faire un circuit limiteur de courant qui dans le cadre d'une application à un tel récepteur s'interpose entre la photodiode et ledit étage d'amplification et limite le courant appliqué audit étage, de manière à éviter que ce courant appliqué ne sorte de la plage de fonctionnement de l'étage, lorsque le signal lumineux reçu par la photodiode a un niveau élevé. Bien entendu, un tel circuit limiteur est également utile dans toute application similaire.

La présente invention a ainsi pour objet tout d'abord un circuit limiteur de courant recevant un courant d'entrée à composante continue non nulle, dont la valeur se situe dans une gamme de courant étendue et fournissant un courant de sortie limité dont la valeur se situe dans une gamme de courant restreinte.

Le circuit limiteur de courant de l'invention, qui est efficace pour une gamme de courant d'entrée étendue et néanmoins simple à mettre en oeuvre et peu onéreux, comprend l'agencement en série d'un premier élément à conductibilité dissymétrique, suivi d'un deuxième élément à conductibilité dissymétrique, lui-même suivi d'un élément résistif, entre les deux pôles d'une source de tension, tel qu'un courant de polarisation traverse les deux éléments à conductibilité dissymétrique et les rende conducteurs, le courant d'entrée, à composante continue non nulle, étant appliqué au point commun des deux éléments à conductibilité dissymétrique et la sortie de courant limité étant obtenue au point commun entre le deuxième élément à conductibilité dissymétrique et l'élément résistif, le sens du courant d'entrée étant tel qu'il se sépare en deux parties, l'une se soustrayant au courant de polarisation, dans le deuxième élément à conductibilité dissymétrique, tandis que l'autre s'ajoute au courant de polarisation, dans le premier élément à conductibilité dissymétrique, augmentant ainsi la résistance dynamique du deuxième élément à conductibilité dissymétrique et diminuant celle du premier élément à conductibilité dissymétrique, ce qui cause la limitation du courant de sortie.

Selon une autre caractéristique de l'invention, lesdits éléments à conductibilité dissymétrique sont des diodes Schottky. Avantageusement, ces diodes sont appairées.

La présente invention a également pour objet un récepteur optique à photodétecteur assurant la conversion d'un signal optique incident en un signal électrique sous forme d'un courant qu'il délivre et étage d'amplification, à basse impédance, du signal électrique, ledit récepteur mettant en application le circuit limiteur de courant selon l'invention. Ce circuit limiteur est interposé entre le photodétecteur et l'étage d'amplification auquel est appliqué son courant de sortie tandis que son courant d'entrée est constitué directement du courant délivré par le photodétecteur.

Les différents objets et caractéristiques de l'invention apparaîtront de façon détaillée dans la description qui va suivre, donnée à titre d'exemple non limitatif, et faite en se reportant aux figures annexées qui représentent :
- la figure 1, le schéma de circuits de réception d'une liaison optique incorporant le circuit limiteur de l'invention,
- la figure 2, la caractéristique tension/courant des diodes du circuit limiteur de la figure 1.

Sur la figure, on trouve un photodétecteur PDA du type générateur de courant c'est-à-dire qui délivre en réponse à un signal optique incident un signal électrique sous forme d'un courant. Ce photodétecteur est ici une photodiode à avalanche. Il peut s'agir par exemple du composant commercialisé sous la référence CG4100 par la Société Alcatel CIT. Cette photodiode a sa cathode connectée au potentiel positif +Vd par une résistance R1 pour sa polarisation.

Elle a sa cathode également connectée à un potentiel +V1, inférieur à Vd, par une diode DP afin de lui assurer, quelle que soit la chute de tension dans la résistance R1, une tension de polarisation minimale, évitant ainsi une diminution de sa bande passante. Un condensateur CP connecté entre la cathode de la photodiode DPA et la masse découple ce circuit d'alimentation.

L'anode de la photodiode est connectée à une borne d'entrée de courant A d'un circuit limiteur de courant constitué de deux éléments à conductibilité dissymétrique D1 et D2 et d'un élément résistif ou résistance RP. Ce circuit limiteur a une borne de sortie de courant limité B connectée à travers un condensateur C à 'un amplificateur PA muni d'une impédance de contre-réaction RC. L'amplificateur PA constitue, avec l'impédance RC, un préamplificateur à transimpédance. Un tel amplificateur à transimpédance est par exemple fourni sous la référence ATA30010 par le constructeur américain ANADIGICS.

Sous l'effet d'un flux lumineux Φ, la photodiode fournit un courant et celui-ci est une fonction croissante du flux lumineux. Ce courant traversant la diode PDA est le courant d'entrée appliqué au circuit limiteur constitué des éléments D1, D2 et RP. En réponse, le circuit limiteur fournit un courant de sortie limité au condensateur C et à l'amplificateur PA. Le courant traversant ainsi le condensateur C est amplifié par l'amplificateur PA.

La gamme des courants d'entrée que peut produire la diode PDA est étendue, alors que la dynamique d'entrée acceptable par le préamplificateur PA pour un fonctionnement correct est plus restreinte. Le circuit limiteur a pour fonction de faire correspondre à chaque courant d'entrée un courant de sortie, la gamme des courants d'entrée étant étendue et correspondant à celle des courants que produit la photodiode PDA, tandis que la gamme des courants de sortie est plus limitée, restant dans la plage de fonctionnement de l'amplificateur PA.

Le circuit limiteur, composé des éléments RP, D2 et D1, est connecté entre les deux bornes d'une source de tension de polarisation, l'une fournissant un potentiel +V et l'autre étant à la masse, de sorte que les trois éléments en série sont parcourus par un courant de polarisation ip. La résistance RP est connectée entre la borne fournissant le potentiel +V et la borne B, l'élément à conductibilité dissymétrique D2 entre les bornes B et A et l'élément à conductibilité dissymétrique D1 entre la borne A et la masse.

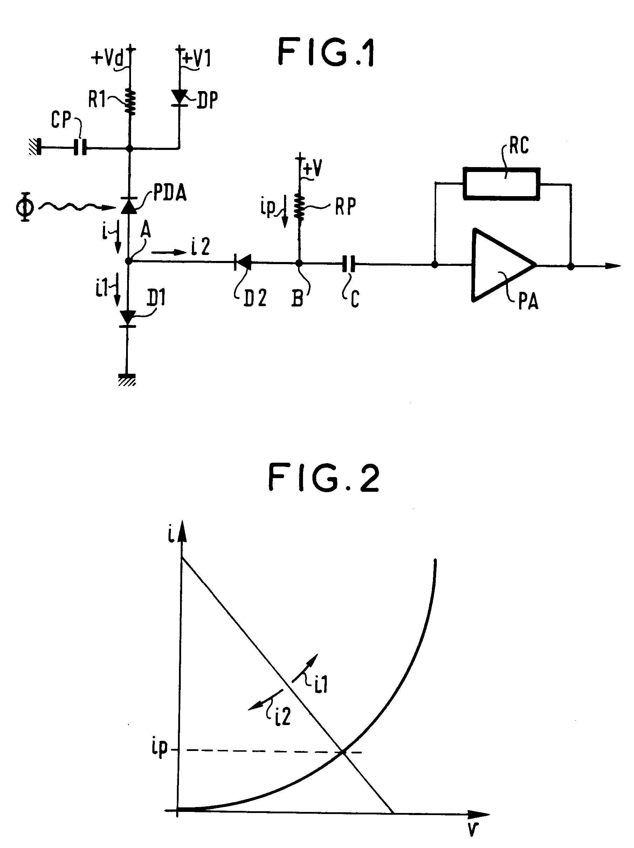

Les éléments à conductibilité dissymétrique D1 et D2 sont de préférence des diodes Schottky dont la caractéristique courant/tension est illustrée à la figure 2. On y a fait figurer une droite de charge correspondant au cas où seul le courant ip parcourt les diodes. Comme on peut le voir, la résistance dynamique de la diode (l'inverse de la pente de la courbe, dv/di) diminue lorsque le courant augmente. En l'absence de tout autre courant, les résistances dynamiques des deux diodes sont égales, puisqu'elles sont traversées par le même courant.

Le circuit limiteur reçoit le courant traversant la photodiode PDA entre les diodes D1 et D2 sur la borne A. Ce courant est formé d'une composante alternative et d'une composante continue représentative de l'amplitude crête à crête de la composante alternative, par exemple, ce qui est souvent le cas, égale à la moitié de cette amplitude. Là, ce courant se divise en deux parties, i2, dans la diode D2 et i1 dans la diode D1. A travers le condensateur C qui bloque la transmission de composante continue à l'amplificateur PA, le courant i2 seul sert à former le courant de sortie du limiteur fourni à l'amplificateur PA et plus précisément le courant appliqué à l'amplificateur PA est constitué sensiblement de la composante alternative du courant i2. Bien entendu, la capacité du condensateur C est calculée pour laisser passer sans les atténuer les signaux en provenance de la photodiode PDA. Le courant i2 se soustrait du courant de polarisation, dans la diode D2, et le courant i1 s'ajoute à ce courant dans la diode D1. L'influence du courant d'entrée i est indiquée à la figure 2 par les flèches i1 et i2. Un accroissement du courant i1, qui déplace le point de fonctionnement de la diode D1 vers le haut de sa caractéristique, diminue la résistance dynamique de cette diode D1. Un accroissement du courant i2, qui déplace le point de fonctionnement de la diode D2 vers le bas de sa caractéristique, augmente la résistance dynamique de la diode D2. La partie i2 du courant i est donc d'autant plus faible, par rapport à la partie i1, que le courant i est plus élevée, ce qui limite le courant de sortie du limiteur. Cette partie ne peut que tendre assymptotiquement à annuler le courant ip, tandis que le courant il tend à constituer la presque totalité du courant d'entrée i. On voit que l'effet maximal de limitation est déterminé par la valeur du courant ip. L'ajustement du circuit limiteur à chaque application revient donc à choisir la valeur de la résistance RP, ce qui s'effectue simplement par l'expérimentation. On a trouvé pratique d'employer des diodes Schottky de caractéristiques identiques, en l'espèce des diodes appairées, livrées dans un boîtier commun.

On notera la simplicité du circuit limiteur de courant selon l'invention dont la caractéristique de transfert courant de sortie/courant d'entrée se trouve définie automatiquement directement par le courant d'entrée à traiter c'est-à-dire dans le cas de l'application envisagée directement par le courant délivré par le photodétecteur du récepteur optique.

## Revendications

1. Circuit limiteur de courant recevant un courant d'entrée à composante continue non nulle, dont la valeur se situe dans une gamme de courant étendue et fournissant un courant de sortie limité dont la valeur se situe dans une gamme de courant restreinte, caractérisé en ce qu'il comprend l'agencement en série d'un premier élément à conductibilité dissymétrique (D1), suivi d'un deuxième élément à conductibilité dissymétrique (D2), lui-même suivi d'un élément résistif (RP), entre les deux pôles d'une source de tension, tel qu'un courant de polarisation (ip) traverse les deux éléments à conductibilité dissymétrique et les rende conducteurs, le courant d'entrée (i) étant appliqué au point commun des deux éléments à conductibilité dissymétrique (D1, D2) et la sortie de courant limité (i2) étant obtenue au point commun entre le deuxième élément à conductibilité dissymétrique (D2) et l'élément résistif (RP), le sens du courant d'entrée étant tel qu'il se sépare en deux parties (i1, i2), l'une (i2) se soustrayant au courant de polarisation (ip), dans le deuxième élément à conductibilité dissymétrique (D2), tandis que l'autre s'ajoute au courant de polarisation (ip), dans le premier élément à conductibilité dissymétrique (D1), augmentant ainsi la résistance dynamique du deuxième élément à conductibilité dissymétrique et diminuant celle du premier élément à conductibilité dissymétrique, ce qui cause la limitation du courant de sortie (i2).

2. Circuit limiteur conforme à la revendication 1, caractérisé en ce que lesdits éléments à conductibilité dissymétrique sont des diodes Schottky.

3. Circuit limiteur conforme à la revendication 2, caractérisé en ce que ces diodes sont appairées.

4. Récepteur optique à photodétecteur assurant la conversion d'un signal optique incident en un signal électrique sous forme d'un courant qu'il délivre et étage d'amplification, à basse impédance, du signal électrique, ledit récepteur mettant en application le circuit limiteur de courant selon l'une des revendications 1 à 3, caractérisé en ce que ledit circuit limiteur est interposé entre le photodétecteur (PDA) et l'étage d'amplification (PA), auquel est appliqué son courant de sortie tandis que son courant d'entrée est constitué directement du courant (i) délivré par le photodétecteur.

## Patentansprüche

1. Strombegrenzerkreis, dem ein Eingangsstrom mit einer Gleichkomponente ungleich Null zugeführt wird, wobei der Wert dieses Eingangsstroms einen weiten Variationsbereich besitzt und wobei ein begrenzter Ausgangsstrom geliefert wird, dessen Wert in einem beschränkten Wertebereich des Stroms variiert, dadurch gekennzeichnet, daß eine Reihenschaltung eines ersten Elements mit unsymmetrischer Leitfähigkeit (D1), eines zweiten Elements mit unsymmetrischer Leitfähigkeit (D2) und eines Widerstandselements (RP) zwischen den beiden Polen einer Spannungsquelle vorgesehen ist, derart, daß ein Gleichstrom (ip) die beiden Elemente mit unsymmetrischer Leitfähigkeit durchfließt und sie leitend macht, wobei der Eingangsstrom (i) an den gemeinsamen Punkt der beiden Elemente mit unsymmetrischer Leitfähigkeit (D1, D2) angelegt wird und der begrenzte Ausgangsstrom (i2) am gemeinsamen Punkt zwischen dem zweiten Element mit unsymmetrischer Leitfähigkeit (D2) und dem Widerstandselement (RP) erhalten wird, wobei die Eingangsstromrichtung so ist, daß dieser Strom sich in zwei Teile (i1, i2) aufteilt, von denen der eine (i2) sich vom Gleichstrom (ip) im zweiten Element mit unsymmetrischer Leitfähigkeit (D2) abzieht, während der andere sich dem Gleichstrom (ip) im ersten Element mit unsymmetrischer Leitfähigkeit (D1) additiv überlagert und so den dynamischen Widerstand des zweiten Elements mit unsymmetrischer Leitfähigkeit vergrößert und den dynamischen Widerstand des ersten Elements mit unsymmetrischer Leitfähigkeit verringert, wodurch sich die Begrenzung des Ausgangsstroms (i2) ergibt.

2. Begrenzerkreis nach Anspruch 1, dadurch gekennzeichnet, daß die Elemente mit unsymmetrischer Leitfähigkeit Schottky-Dioden sind.

3. Begrenzerkreis nach Anspruch 2, dadurch gekennzeichnet, daß die Dioden paarweise ausgesucht sind.

4. Optischer Empfänger mit einem Fotodetektor, der ein einfallendes optisches Signal in ein elektrisches Signal in Form eines Ausgangsstroms umwandelt, und mit einer Verstärkungsstufe geringer Impedanz für das elektrische Signal, wobei der Empfänger den Strombegrenzungskreis gemäß einem der Ansprüche 1 bis 3 verwendet, dadurch gekennzeichnet, daß der Begrenzungskreis zwischen den Fotodetektor (PDA) und die Verstärkungsstufe (PA) eingefügt ist, an die der Ausgangsstrom dieses Kreises angelegt wird, während der Eingangsstrom dieses Kreises unmittelbar von dem vom Fotodetektor gelieferten Strom (i) gebildet wird.

## Claims

1. A current limiter circuit receiving an input current having a non-zero DC component whose value lies in a wide range of current values, and delivering a limited output current whose value lies in a narrower range of current values, the limiter circuit being characterized in that it comprises a series connection of a first asymmetrical conductivity element (D1) followed by a second asymmetrical conductivity element (D2) which is followed in turn by a resistive element (RP), the series connection extending between two poles of a voltage source so that a bias current (ip) flows through the asymmetrical conductivity elements and makes them conductive, with the input current (i) being applied to the common point between the two asymmetrical conductivity elements (D1, D2) and with the current-limited output (i2) being taken from the common point between the second asymmetrical conductivity element (D2) and the resistive element (RP), the direction of the input current flow being such that it splits into two fractions (i1, i2), with one of the fractions (i2) being subtracted from the bias current (i2) in the second asymmetrical conductivity element (D2), while the other fraction is added to the bias current (i2) in the first asymmetrical conductivity element (D1), thereby increasing the dynamic resistance of the second asymmetrical conductivity element and reducing the dynamic resistance of the asymmetrical conductivity element, thus limiting the output current (i2).

2. A limiter circuit according to claim 1, characterized in that the said asymmetrical conductivity elements are Schottky diodes.

3. A limiter circuit according to claim 2, characterized in that the diodes are paired.

4. An optical receiver having a photodetector which converts an incident optical signal into an electrical signal in the form of a current which it delivers to a low impedance amplification stage for the electrical signal, the receiver implementing the current limiter circuit of any one of claims 1 to 3, the receiver being characterized in that said limiter circuit is interposed between the photodetector (PDA) and the amplification stage (PA) to which the output current from the limiter circuit is applied with the input current to the limiter circuit being directly constituted by the current (i) delivered by the photodetector.
